# EUROPÄISCHE PATENTSCHRIFT

(11) **EP 3 251 214 B1**
(45) Veröffentlichungstag und Bekanntmachung des Hinweises auf die Patenterteilung: **05.08.2020**
(21) Anmeldenummer: 16704547.5
(22) Anmeldetag: 22.01.2016
(51) Int. Cl.: H03K 17/96, H05K 1/11, G06F 3/044

(54) **FUNKTIONSFOLIE ZUM AUFBRINGEN AUF EIN BELIEBIG ABLÄNGBARES PROFILTEIL UND PROFILTEIL**
FUNCTIONAL FOIL FOR APPLYING TO A PROFILED PART THAT CAN BE CUT TO ANY LENGTH, AND PROFILED PART
FILM FONCTIONNEL À APPLIQUER SUR UNE PIÈCE PROFILÉE SECTIONNABLE À VOLONTÉ, ET PIÈCE PROFILÉE

(30) Priorität: 28.01.2015 DE 102015101245
(43) Veröffentlichungstag der Anmeldung: 06.12.2017
(73) Patentinhaber: REHAU AG + Co, 95111 Rehau (DE)
(72) Erfinder: NIEHOFF, Ansgar, 95111 Rehau (DE); SCHMIDT, Steven, 95182 Döhlau (DE); RAMSAUER, Christoph, 4701 Bad Schallerbach (AT); WEISSEL, Philipp, 4020 Linz (AT)
(74) Vertreter: Lindner Blaumeier Patent- und Rechtsanwälte
(86) Internationale Anmeldenummer: PCT/EP2016/051288
(87) Internationale Veröffentlichungsnummer: WO 2016/120157

(56) Entgegenhaltungen:
- WO-A2-2009/138569
- US-A1- 2011 163 999

## Beschreibung

Die Erfindung betrifft eine Funktionsfolie zum Aufbringen auf ein beliebig ablängbares Profilteil, insbesondere auf ein Endlosprofil, aufweisend wenigstens eine Schaltungsträgerschicht mit sich periodisch wiederholenden Berührungssensorleiterflächen und Betriebsleiterbahnen zum Signaltransport zu und/oder von den durch die Berührungssensorleiterflächen gebildeten Berührungssensoren. Daneben betrifft die Erfindung ein Profilteil, auf das eine derartige Funktionsfolie aufgebracht ist, und ein Verfahren zu dessen Herstellung.

Derartige Funktionsfolien, die neben einer dekorativen, informativen, schützenden und/oder sonstigen Wirkung auch elektrische und/oder elektronische Funktionen realisieren können, wurden im Stand der Technik bereits vorgeschlagen. Insbesondere lassen sich derartige Funktionsfolien auf Kunststoffbauteile, konkret Profilteile, kaschieren. Derartige Profilteile liegen üblicherweise als sogenanntes Endlosprofil vor, so dass die Funktionsfolie üblicherweise auch als Endlosfolie produziert wird. Die mit der Funktionsfolie kaschierten Profilteile, die entsprechend in der benötigten Länge abgelängt wurden, stellen dann die entsprechende elektrische beziehungsweise elektronische Funktion zur Verfügung, insbesondere, nachdem entsprechende Verbindungen mit weiteren elektrischen beziehungsweise elektronischen Bauteilen realisiert wurden. So entstehen beispielsweise Bedienteile für elektrische Verbraucher, beispielsweise Waschmaschinen und dergleichen, es ist jedoch auch denkbar, an Möbeln, Wandverkleidungen, Fenster- und Türrahmen und anderweitigen Profilteilen elektrische Funktionen und/oder Bedienfunktionen letztlich integriert in das Profilteil anzubieten.

Besonders vorteilhaft ist es dabei, Berührungssensoren (Touchsensoren) durch derartige Funktionsfolien zu realisieren, welche dann auch als "Touchfolie" bezeichnet werden können. Die Berührungssensoren lassen sich beispielsweise kapazitiv leicht über entsprechende Berührungssensorleiterflächen umsetzen. Auf diese Weise wird die Oberfläche des Profilteils zu einem Berührungsbedienfeld (Touchbedienfeld), mit dem sich insbesondere elektrische Verbraucher steuern lassen. Problematisch ist, dass jedoch elektronische Auswerteeinheiten für die Berührungssensoren benötigt werden, die auch als Steuereinheiten bezeichnet werden können. Derartige Auswerteeinheiten sind in der Lage, Signale von einer bestimmten Anzahl von Berührungssensoren entgegenzunehmen und zu verarbeiten, so dass bis zu einer gewissen Länge der Funktionsfolie eine einzige Auswerteeinheit ausreichend ist, beispielsweise bis von einer Länge von etwa 60 cm.

Wie bereits erwähnt wurde, lassen sich solche Funktionsfolien besonders vorteilhaft jedoch auf Endlosprofile kaschieren, wobei eine Funktionsfähigkeit der Berührungssensorik über beliebige Längen nur dann gewährleistet werden kann, wenn in bestimmten, regelmäßigen Abständen Auswerteeinheiten zur Verfügung stehen. Daher wurde vorgeschlagen, in sich periodisch wiederholenden Abständen auf der Funktionsfolie Auswerteeinheiten, insbesondere Mikrocontroller, aufzubringen, um so beliebig lange Profilteile realisieren zu können.

Dies hat jedoch den Nachteil, dass durch die Platzierung von Auswerteeinheiten, insbesondere Mikrocontroller, auf der Funktionsfolie diese unflexibel wird, so dass die häufig eingesetzte Rolle-zu-Rolle-Verarbeitung nicht mehr möglich ist. Dies hat zur Folge, dass der Kaschierprozess mit einer solchen Funktionsfolie aufwendig ist. Ferner besteht das Problem, dass beim Ablängen von Profilen mit kaschierter Funktionsfolie inklusive Auswerteeinheiten darauf geachtet werden muss, dass die Auswerteeinheiten nicht durchtrennt werden.

Aus WO 2012/170716 A2 ist ein Bedienpanel für ein Elektrogerät bekannt, wobei die verwendete dekorative Plastikfolie auch elektronische Zusatzfunktionen enthalten kann, mithin als eine Funktionsfolie realisiert ist.

WO 2009/138 569 A2 betrifft einen Sensor zur Detektion von leitfähigen Körpern, der sich durch eine bestimmte, die Sensitivität erhöhende Geometrie auszeichnet. Der Sensor kann Metallfolien, die an einer Plastikfolie befestigt sind, aufweisen und flexibel sein, um in Rollen gelagert zu werden, wobei ein im Wesentlichen gleiches Elektrodenmuster periodisch entlang eines "Web" wiederholt wird.

US 2011/0 163 999 A1 betrifft eine Berührungssteuervorrichtung, die eine Halterung, eine erste Leiterplatte und eine zweite Leiterplatte, die elektrisch miteinander verbunden sind, und eine Lichtleitfolie umfasst. Die zweite Leiterplatte kann auf der Oberfläche der ersten Leiterplatte errichtet sein, eine gekurvte Form aufweisen und Anschlüsse umfassen.

Der Erfindung liegt die Aufgabe zugrunde, eine Möglichkeit zur besseren Handhabung von Funktionsfolien beziehungsweise zur einfacheren Herstellung von mit Funktionsfolie kaschierten Profilteilen beliebiger Längen anzugeben.

Zur Lösung dieser Aufgabe sind bei einer Funktionsfolie der eingangs genannten Art erfindungsgemäß die Merkmale des Anspruchs 1 vorgesehen.

Dies bedeutet also insbesondere, dass die Betriebsleiterbahnen von dem wenigstens einen Berührungssensor zu einem zu bzw. an einem Rand der Funktionsfolie ausgebildeten Anschlussbereich geführt sind. Durch die Berührungssensorleiterfläche ist insbesondere ein Berührungssensor mit einem kapazitiven Funktionsprinzip gebildet.

Erfindungsgemäß wird mithin vorgeschlagen, die Funktionsfolie (Touchfolie) und die Auswerteeinheiten (insbesondere im Sinne einer starren Baueinheit, die beispielsweise einen Mikrocontroller mit zugeordneten Anschlusseinrichtung umfassen kann) räumlich voneinander zu trennen, indem für die Funktionsfolie in bestimmten, festen Abständen Anschlussbereiche realisiert sind, die es, wie im Folgenden noch näher dargelegt werden wird, auf besonders einfache Weise ermöglichen, nach dem Aufbringen, insbesondere Aufkaschieren, der durch Weglassen steiferer Teile flexiblen Funktionsfolie die benötigte Anzahl von Auswerteeinheiten, insbesondere Mikrocontroller, nachzurüsten. Mithin erlaubt es die Erfindung, Profilteile endlos mit Funktionsfolien, die keine steifen elektronischen Komponenten tragen, zu kaschieren. Diese kaschierten Profilteile lassen sich beliebig ablängen. Später, insbesondere erst bei der Endmontage des kaschierten Profilteils, beispielsweise eines Wandanschlussprofils, wird die benötigte Anzahl an Auswerteeinheiten auf das Profilteil aufgebracht und somit elektrisch- und signalleitend mit den Anschlussbereichen verbunden. Denkbar ist es neben einem Aufkaschieren in einer vorteilhaften Ausführungsform auch, die Funktionsfolie beim Extrusionsprozess aufzubringen, mithin beispielsweise mit "Einlaufen" zu lassen.

Somit enthält die Funktionsfolie die Berührungssensoren an sich sowie die Betriebsleiterbahnen für die Berührungssensoren, nicht aber die Auswerteeinheiten. Hierdurch bleibt die Funktionsfolie beliebig flexibel und kann in einem Rolle-zu-Rolle-Verfahren mit dem Profilteil verbunden oder anderweitig verarbeitet werden. Es wird ein einfaches Ablängen der Funktionsfolie ermöglicht, nachdem sich die Auswerteeinheiten nicht mehr darauf befinden. Dabei wird darauf hingewiesen, dass selbstverständlich auch andere elektrische und/oder elektronische Strukturen auf der Funktionsfolie vorgesehen sein können, so lange die Flexibilität und beliebige Ablängbarkeit nicht in Frage gestellt wird.

Je nach den verfügbaren Auswerteeinheiten beziehungsweise der konkreten Ausgestaltungen der Schaltungsträgerschicht kann beispielsweise ein Anschlussbereich jeweils für wenigstens zehn Berührungssensoren, beispielsweise 25 Berührungssensoren, vorgesehen sein. Diese Zahlen sind selbstverständlich beispielhaft zu verstehen, wobei allerdings die Kosten der erfindungsgemäßen Lösung mit steigender Anzahl von Berührungssensoren pro Anschlussbereich weiter vorteilhaft sinken. Werden die Berührungssensoren, wie bereits beschrieben, durch eine Berührungssensorleiterfläche kapazitiv gebildet, sind Ausgestaltungen bekannt, in denen eine Betriebsleiterbahn pro Berührungssensor ausreicht, um die durch die kapazitiven Wechselwirkungen entstandenen Signale zum Anschlussbereich und über diesen zur Auswerteeinheit zu führen, welche insbesondere dann, wenn sie auch Steueraufgaben übernimmt, auch als Steuereinheit bezeichnet werden kann.

Es ist ferner vorgesehen, dass die Schaltungsträgerschicht ferner wenigstens eine Energieversorgungsleiterbahn und/oder wenigstens eine Kommunikationsleiterbahn für die Auswerteeinheiten aufweist, wobei die Energieversorgungsleiterbahn und/oder die Kommunikationsleiterbahn jeweils von einem Anschlussbereich zu dem nächsten Anschlussbereich geführt sind. Auf diese Weise ist mithin auch die Strom- und/oder Datenversorgung für die Auswerteeinheiten auf der Funktionsfolie integriert, so dass sich die Auswerteeinheiten bei der Endmontage des kaschierten Profilteils besonders einfach und schnell über die Anschlussbereiche kontaktieren lassen, wobei, wie im Folgenden noch näher dargelegt wird, die Kontaktierung besonders vorteilhaft über eine zuverlässige Steckverbindung erfolgt. Insbesondere werden die Energieversorgungsleiterbahnen und die Kommunikationsleiterbahnen jeweils von Anschlussbereich zu Anschlussbereich geführt, so dass auch bei einer Mehrzahl von Auswerteeinheiten diese problemlos in Reihe geschaltet werden können, ohne dass bei mehreren Auswerteeinheiten entlang des Profilteils beispielsweise mehrere Stromversorgungen realisiert werden müssten. Die Kommunikationsleiterbahnen können in diesem Kontext besonders vorteilhaft als Busleiterbahnen für einen Kommunikationsbus realisiert werden. Für jedes Profilteil mit mehr als einer Auswerteeinheit kann dann beispielsweise eine der Steuerung des Gesamtprofilteils dienende elektronische Zentraleinheit an einem Längsende des kaschierten Profilteils vorgesehen werden, welche mit den Kommunikationsleiterbahnen und/oder den Stromleiterbahnen verbunden wird und selbst jeweils mit einer externen Stromversorgung verbunden ist, beispielsweise mit dem Haushaltsstrom. Bevorzugt ist es jedoch, eine Auswerteeinheit als Zentraleinheit auszubilden und sie über einen Anschlussbereich zu verbinden.

In besonders vorteilhafter Ausgestaltung der vorliegenden Erfindung kann vorgesehen sein, dass die Berührungssensoren in Längsrichtung der Funktionsfolie aufeinanderfolgen, wobei die ebenso in Längsrichtung aufeinanderfolgenden Anschlussbereiche auf seitlich aus der Funktionsfolie ausgebildeten Anschlussfahnen vorgesehen sind. Das bedeutet, in der beschriebenen Ausgestaltung werden die Anschlussbereiche durch Anschlussfahnen gebildet, die seitlich in regelmäßigen Abständen aus der Funktionsfolie herausragen und dort zum Anschluss der Auswerteeinheiten genutzt werden können. Besonders vorteilhaft ist es in diesem Zusammenhang, wenn das Profilteil und die Funktionsfolie aufeinander abgestimmt sind, so dass eine bevorzugte Weiterbildung der erfindungsgemäßen Funktionsfolie vorsieht, dass die Anschlussfahnen zum abgeknickten Aufbringen an einer Kante, insbesondere eines Stegs, und/oder zum Einbringen in eine Nut des mit der Funktionsfolie abgestimmten Profilkörpers des Profilteils ausgebildet sind. Handelt es sich bei dem Profilteil beispielsweise um ein T-Profilteil, weist das Profilteil einen Steg auf, der genutzt werden kann, um die entsprechend abgeknickten Schlussfahnen im 90°-Winkel abgeknickt zur restlichen Funktionsfolie aufzubringen. Durch eine entsprechende Ausgestaltung des Profilteils und die abgeknickte und/oder in eine Nut eingelagerte Aufbringung der Anschlussfahnen lassen sich besonders zweckmäßig Aufsteckbereiche für die Auswerteeinheiten definieren, die eine besonders einfache und gegebenenfalls auch zwangsläufig korrekte Montage der Auswerteeinheiten erlauben. Selbstverständlich muss in solchen Aufsteckbereichen nicht zwangsläufig unmittelbar die Auswerteeinheit befestigt werden, sondern es liegt auch im Rahmen der vorliegenden Erfindung, einen entsprechenden Anschlussstecker einer Kabelverbindung zu der Auswerteeinheit aufzustecken.

Zweckmäßigerweise kann zusätzlich zu der Schaltungsträgerschicht wenigstens eine dekorative und/oder mechanisch stabilisierende und/oder als Schirmlage wirkende und/oder eine Schirmlage umfassende Zusatzschicht vorgesehen sein. Eine derartige, grundsätzlich im Stand der Technik bekannte Ausgestaltung kann auch im Rahmen der vorliegenden Erfindung zweckmäßig eingesetzt werden. So können beispielsweise die Schaltungsträgerschichten mit stützenden und/oder dekorativen Kunststoffschichten verklebt, verpresst, verspritzt oder anderweitig verbunden werden. So wird eine Funktionsfolie erhalten, die elektrische beziehungsweise elektronische wie auch mechanische beziehungsweise stützende und/oder dekorative Funktionen in sich vereint. Dabei sei darauf hingewiesen, dass selbstverständlich auch Ausgestaltungen denkbar sind, in denen die Schaltungsträgerschicht selbst als eine dekorative/stützende Wirkung aufweisend ausgebildet ist und/oder mehrere Schaltungsträgerschichten vorgesehen sind. Eine eine beispielsweise aus Kupfer gebildete Schirmlage aufweisende Zusatzschicht ist insbesondere in einer Ausgestaltung günstig, wenn die Schaltungsträgerschicht derart um die mittig vorgesehene Zusatzschicht gelegt ist, dass die Schirmlage, welche auch als Bezugspotential für den kapazitiven Berührungssensor dienen kann, die Berührungssensorleiterfläche gegen die auf der gegenüberliegende Seite verlaufenden Leiterbahnen abschirmt, insbesondere Betriebsleiterbahnen anderer Berührungssensorleiterflächen, Kommunikationsleiterbahnen und Energieversorgungsleiterbahnen.

Wie bereits ausgeführt wurde, ist aufgrund des Weglassens der Auswerteeinheiten die Funktionsfolie äußerst flexibel, so dass vorteilhaft vorgesehen sein kann, dass die Funktionsfolie auf einer Trägerrolle aufgerollt ist.

Neben der Funktionsfolie betrifft die vorliegende Erfindung auch ein Profilteil, aufweisend einen Profilkörper, eine auf wenigstens eine Seite des Profilkörpers kontinuierlich aufgebrachte, insbesondere aufkaschierte Funktionsfolie der erfindungsgemäßen Art und an den Anschlussbereichen angeschlossene Auswerteeinheiten, insbesondere als oder umfassend Mikrocontroller. Sämtliche Ausführungen zur erfindungsgemäßen Funktionsfolie lassen sich analog auf das erfindungsgemäße Profilteil, welches insbesondere von einem Endlosprofil abgelängt ist, übertragen, so dass die bereits beschriebenen Vorteile insbesondere bei der Herstellung des Profilteils gegeben sind.

Zweckmäßigerweise kann der Profilkörper einen Steg aufweisen, an dessen einer Seite die seitlich aus der Funktionsfolie ausgebildeten Anschlussfahnen mit den Anschlussbereichen abgeknickt von der restlichen Funktionsfolie anliegen. Wie bereits bezüglich der Funktionsfolie dargelegt, bietet sich ein Steg besonders an, um die restliche Funktionsfolie an diesen angrenzend aufzubringen, so dass die Anschlussfahnen um 90° abgeknickt entlang der Seitenfläche des Stegs weiterverlaufen, wo durch den Anschlussbereich eine Anschlussposition, insbesondere ein Aufsteckbereich, definiert wird. Im Steg kann bei einer weiteren Abstimmung der Funktionsfolie auf das Profil auch eine Nut im Bereich der Anschlussfahnen vorgesehen werden. Das Profilteil kann in diesem Kontext insbesondere ein T-Profilteil sein. Es sei angemerkt, dass Nuten zur Aufnahme der Anschlussfahnen auch anstatt eines Stegs am Profilkörper vorgesehen sein können.

Besonders zweckmäßig ist es, wenn die Länge der Anschlussfahnen der Höhe des Stegs entspricht. Dann enden letztlich die Anschlussfahnen und insbesondere auch die dort vorhandenen Leiterbahnen, also wenigstens die Betriebsleiterbahnen, auch am oberen Ende des Stegs, was ein Aufstecken von kontaktierenden Teilen, insbesondere also der Auswerteeinheiten selber und/oder von Kabelverbindungen mit Steckern für die Auswerteeinheiten, vereinfacht.

Wie bereits angedeutet wurde, sind vorzugsweise im Bereich der Anschlussfahnen entlang des Stegs durch diese Aufsteckbereiche definiert, auf die die Auswerteeinheiten und/oder ein Stecker einer Kabelverbindung zur Verbindung mit den Auswerteeinheiten, die Leiterbahnen des jeweiligen Anschlussbereichs kontaktierend, aufgesteckt sind. Die Definition bzw. Ausgestaltung des Aufsteckbereichs kann weiter durch eine entsprechende Ausbildung des Profilkörpers verfeinert werden; insgesamt ergibt sich so eine einfache Möglichkeit zur Kontaktierung der Auswerteeinheiten, nachdem eine solche Steckverbindung einfach und zuverlässig ist und auf das auszusteckende Teil, also die Auswerteeinheit selber oder einen Stecker einer Kabelverbindung zu der Auswerteeinheit, abgestimmt werden kann.

Schließlich betrifft die Erfindung auch ein Verfahren zur Herstellung eines Profilteils mit Berührungssensoren, wobei in einem ersten Schritt eine erfindungsgemäße Funktionsfolie auf den Profilkörper eines Endlosprofils aufgebracht wird, insbesondere durch Kaschieren, in einem zweiten Schritt das Profilteil einer gewünschten Länge von dem Endlosprofil abgelängt wird und in einem dritten Schritt wenigstens eine Auswerteeinheit an den wenigstens einen Anschlussbereich auf dem Profilteil angeschlossen wird. Auch auf das Verfahren lassen sich die bisherigen Ausführungen sinngemäß übertragen. Insbesondere ist es also denkbar, ein Endlosprofil (als langes Profilteil) kontinuierlich mit der Funktionsfolie zu kaschieren, um von diesem Profilteile beliebiger Länge abzutrennen. Auch ein Aufbringen im oder unmittelbar anschließend an einen Extrusionsprozess ist möglich.

Weitere Vorteile und Einzelheiten der vorliegenden Erfindung ergeben sich aus den im Folgenden beschriebenen Ausführungsbeispielen sowie anhand der Zeichnung. Dabei zeigen:
- Fig. 1: eine Aufsicht auf ein Ausführungsbeispiel einer erfindungsgemäßen Funktionsfolie,
- Fig. 2: ein Querschnitt durch die Funktionsfolie nach Fig. 1 im Bereich einer Anschlussfahne,
- Fig. 3: ein Ausführungsbeispiel eines erfindungsgemäßen Profilteils, bei dem die Auswerteeinheiten noch nicht aufgesetzt sind, und
- Fig. 4: eine aufgesteckte Auswerteeinheit.

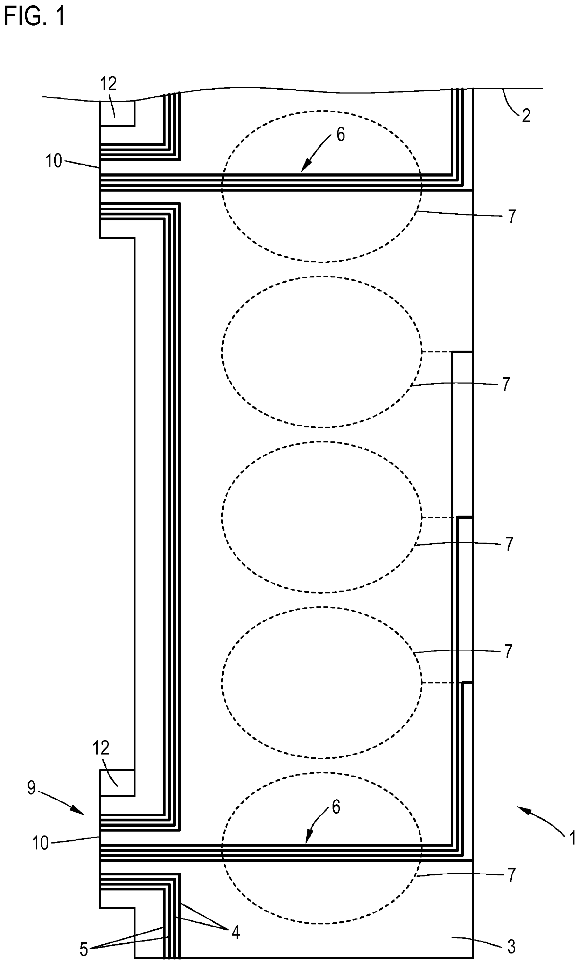

Fig. 1 zeigt eine Aufsicht auf ein Ausführungsbeispiel einer erfindungsgemäßen Funktionsfolie 1. Diese ist als eine auf eine Trägerrolle aufrollbare, sogenannte Endlosfolie ausgeführt, was durch die Abbruchlinie 2 verdeutlicht wird.

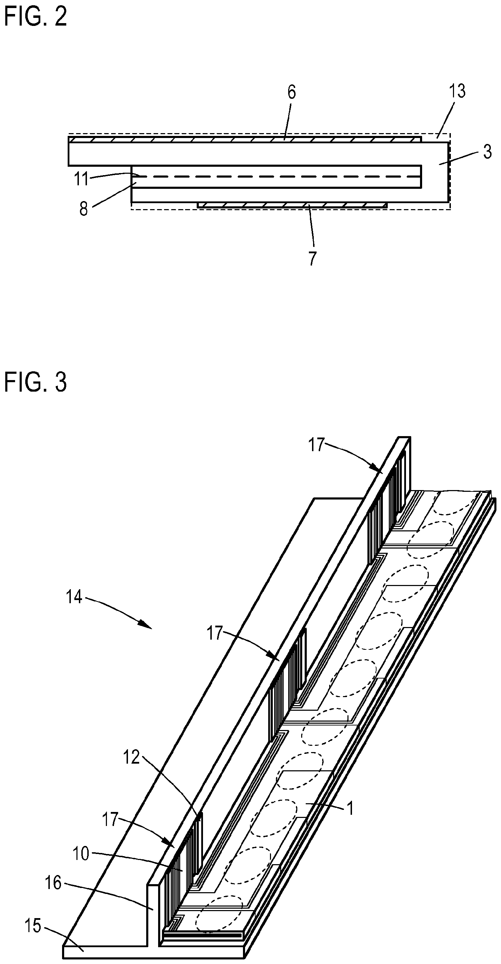

Die Funktionsfolie 1, welche in Fig. 2 im Schnitt gezeigt ist, umfasst dabei eine Schaltungsträgerschicht 3 mit darauf befindlichen, im Folgenden noch näher erläuterten Leiterbahnen und Leiterflächen 4, 5, 6 und 7, die vorliegend um eine Zusatzschicht 8 herumgelegt ist. Sowohl die Trägerschicht 3 als auch die Zusatzschicht 8 können jeweils auf einer Polyesterfolie basieren.

Ersichtlich weist die Funktionsfolie 1 auf dem unteren Teil der Schaltungsträgerschicht 3 aufeinanderfolgende Berührungssensorleiterflächen 7 auf, wobei jede dieser Berührungssensorleiterflächen 7, die einen kapazitiven Berührungssensor bildet, durch eine Betriebsleiterbahn 6 ausgelesen werden kann. Seitlich benachbart jeder fünften Berührungssensorleiterfläche 7 ist aus dem oberen Teil der Schaltungsträgerschicht 3 als Anschlussbereich 9 eine Anschlussfahne 10 ausgebildet, zu der die Betriebsleiterbahnen 6 geführt sind. Die verschiedenen Leiterbahnen 4 und 5 verbinden benachbarte Anschlussfahnen 10, wobei jeweils zwei Energieversorgungsleiterbahnen 4 und zwei Kommunikationsleiterbahnen 5 vorgesehen sind. Um die Berührungssensorleiterflächen 7 gegenüber den Leiterbahnen 4, 5 und 6 abzuschirmen, weist die Zusatzschicht 8 eine Schirmlage 11 aus Kupfer auf. Um diese Schirmlage 11 mit Masse kontaktieren zu können, ist im Bereich der Anschlussfahnen 10 auch aus der Zusatzschicht 8 eine weitere Anschlussfahne 12 gleicher Ausdehnung ausgebildet, die der Anschlussfahne 10 unmittelbar benachbart sein kann, jedoch auch von dieser um einen insbesondere eher kleinen Abstand im Vergleich zum Abstand der Anschlussfahnen 10 beabstandet sein kann.

An jeweils einem Paar von Anschlussfahnen 10, 12, gegebenenfalls auch nur an den Anschlussfahnen 10, kann direkt oder indirekt eine Auswerteeinheit, die nicht Teil der Funktionsfolie 1 ist, angeschlossen werden.

Um die Leiterbahnen 4, 5 und 6 sowie die Leiterflächen 7 nach außen hin elektrisch zu isolieren und zu schützen, sind zumindest die die Leiterbahnen 4, 5 und 6 beziehungsweise Leiterflächen 7 enthaltenden Anteile der Funktionsfolie 1 mit einem Isolationslack 13 überzogen, wobei alternativ auch eine isolierende Folienbeschichtung möglich ist.

Ersichtlich ist zum Zwecke der besseren Darstellung im vorliegenden Ausführungsbeispiel jede Anschlussfahne 10 vier Berührungssensoren zugeordnet; selbstverständlich sind auch Ausführungsbeispiele denkbar, in denen eine kleinere oder (üblicherweise) größere Zahl von Berührungssensoren über eine Anschlussfahne 10 ausgelesen werden kann.

Nachdem die Funktionsfolie 1 keinerlei steife elektronische Bauteile enthält, insbesondere keine Auswerteeinheiten, die üblicherweise als Mikrocontroller ausgebildet sind bzw. einen solchen umfassen, aufweist, kann sie aufgerollt werden und mithin beispielsweise in einem Rolle-zu-Rolle-Verfahren auf ein Profilteil, welches insbesondere als Endlosprofil ausgebildet ist, aufgebracht werden. Das so kaschierte Profilteil kann beliebig abgelängt werden, ohne dass das Risiko besteht, eine Auswerteeinheit zu zerteilen.

Fig. 3 zeigt ein erfindungsgemäßes Profilteil 14, hier ein T-Profil, welches mithin einen T-förmigen Profilkörper 15 aufweist, der vorliegend aus Kunststoff besteht. Beispielsweise kann es sich bei dem Profilteil 14 um ein Wandanschlussprofil handeln, welches oft in unterschiedlichen Längen benötigt wird.

Auf den Profilkörper 15 ist bereits die erfindungsgemäße Funktionsfolie 1 aufkaschiert, vorliegend auf die Rückseite, so dass die kapazitiven Berührungssensorleiterflächen 7 profilkörperseitig angeordnet sind. Die Funktionsfolie 1 ist so aufgebracht, dass ihr Hauptkörper an dem Steg 16 entlang verläuft, so dass die Anschlussfahnen 10, 12 im 90° Winkel abgeknickt aufkaschiert sind und entlang des Steges 16 nach oben verlaufen. Ersichtlich sind die Anschlussfahnen 10, 12 derart bemessen, dass sie exakt die Höhe des Steges 16 abdecken.

Hierdurch wird am Steg ein Aufsetzbereich 17 gebildet, in dem problemlos die Auswerteeinheiten beziehungsweise entsprechende Stecker von Kabelverbindungen für die Auswerteeinheiten aufgesetzt werden können.

In anderen Ausführungsbeispielen kann dieses Aufsetzverhalten noch verbessert werden, indem entlang des Stegs 16 Nuten vorgesehen sind, die zur Aufnahme der Anschlussfahnen 10, 12 und/oder zur Führung einer aufgesetzten Auswerteeinheit und/oder eine aufgesetzten Steckers dienen können. Derartige Nuten sind hier der Übersichtlichkeit halber nicht dargestellt.

Das in Fig. 3 dargestellte Ausführungsbeispiel des Profilteils 14 ist so abgelängt, dass drei Auswerteeinheiten für die dort zehn dargestellten Berührungssensoren eingesetzt werden. Jeweils in den Aufsteckbereichen 17 wird dann ein hier noch nicht dargestellter Mikrocontroller als Auswerteeinheit aufgesetzt, so dass entsprechende Anschlüsse der Auswerteeinheit die Enden der Leiterbahnen 4, 5 und 6 kontaktieren. Zur Steuerung des Gesamtbetriebs kann eine dieser Auswerteeinheiten als Master-Auswerteeinheit ausgebildet sein; es kann selbstverständlich auch vorgesehen sein, dass unmittelbar oder über eine Kabelverbindung eine andere Anschlussvariante gewählt wird. Bevorzugt ist jedoch, dass die Auswerteeinheit als eine Auswerteeinheit ebenso auf den Steg 16 aufsitzt.

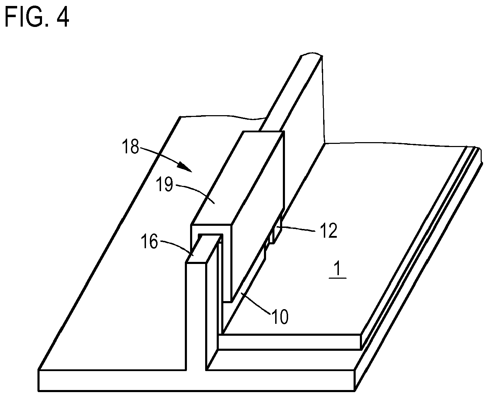

Fig. 4 zeigt in Form einer Prinzipskizze eine im Aufsteckbereich 17 des Stegs 16 auf diesen aufgesetzte, die Anschlussfahnen 10, 12 kontaktierende Auswerteeinheit 18, die hier einen Mikrocontroller 19 umfasst.

Durch das Aufkaschieren der Funktionsfolie 1 und das Versehen mit Auswerteeinheiten 18 wirkt somit die glatte Vorderseite des Profilkörpers 15 als berührungsempfindliche Schaltfläche für beliebige elektrische Verbraucher.

## Patentansprüche

1. Funktionsfolie (1) zum Aufbringen auf ein beliebig ablängbares Profilteil (14), insbesondere auf ein Endlosprofil, aufweisend wenigstens eine Schaltungsträgerschicht (3) mit sich periodisch wiederholenden Berührungssensorleiterflächen (7) und Betriebsleiterbahnen (6) zum Signaltransport zu und von den durch die Berührungssensorleiterflächen (7) gebildeten Berührungssensoren, wobei die Funktionsfolie (1) sich periodisch wiederholende Anschlussbereiche (9) zum Anschluss einer Auswerteeinheit (18), insbesondere eines Mikrocontrollers (19), für jeweils wenigstens einen Berührungssensor aufweist,
**dadurch gekennzeichnet, dass** die Schaltungsträgerschicht (3) ferner wenigstens eine Energieversorgungsleiterbahn (4) und/oder wenigstens eine Kommunikationsleiterbahn (5) für die Auswerteeinheiten (18) aufweist, wobei die Energieversorgungsleiterbahn (4) und/oder die Kommunikationsleiterbahn (5) jeweils von einem Anschlussbereich (9) zu dem nächsten Anschlussbereich (9) geführt sind.

2. Funktionsfolie nach Anspruch 1, **dadurch gekennzeichnet, dass** ein Anschlussbereich (9) jeweils für wenigstens zehn Berührungssensoren vorgesehen ist.

3. Funktionsfolie nach einem der vorangehenden Ansprüche, **dadurch gekennzeichnet, dass** die Berührungssensoren in Längsrichtung der Funktionsfolie (1) aufeinander folgen, wobei die ebenso in Längsrichtung aufeinanderfolgenden Anschlussbereiche (9) auf seitlich aus der Funktionsfolie (1) ausgebildeten Anschlussfahnen (10) vorgesehen sind.

4. Funktionsfolie nach Anspruch 3, **dadurch gekennzeichnet, dass** die Anschlussfahnen (10) zum abgeknickten Aufbringen an einer Kante und/oder zum Einbringen in eine Nut des mit der Funktionsfolie (1) abgestimmten Profilkörpers (15) des Profilteils (14) ausgebildet sind.

5. Funktionsfolie nach einem der vorangehenden Ansprüche, **dadurch gekennzeichnet, dass** zusätzlich zu der Schaltungsträgerschicht (3) wenigstens eine dekorative und/oder mechanisch stabilisierende und/oder als Schirmlage (11) wirkende und/oder eine Schirmlage (11) umfassende Zusatzschicht (8) vorgesehen ist und/oder die Funktionsfolie (1) auf einer Trägerrolle aufgerollt ist.

6. Profilteil (14), aufweisend einen Profilkörper (15), eine auf wenigstens eine Seite des Profilkörpers (15) kontinuierlich aufgebrachte, insbesondere aufkaschierte Funktionsfolie (1) nach einem der vorangehenden Ansprüche, und an den Anschlussbereichen (9) angeschlossene Auswerteeinheiten (18), insbesondere Mikroprozessoren (19).

7. Profilteil nach Anspruch 6, **dadurch gekennzeichnet, dass** der Profilkörper (15) einen Steg (16) aufweist, an dessen einer Seite die seitlich aus der Funktionsfolie (1) ausgebildeten Anschlussfahnen (10) mit den Anschlussbereichen (9) abgeknickt von der restlichen Funktionsfolie (1) anliegen.

8. Profilteil nach Anspruch 7, **dadurch gekennzeichnet, dass** die Länge der Anschlussfahnen (10) der Höhe des Stegs (16) entspricht.

9. Profilteil nach Anspruch 7 oder 8, **dadurch gekennzeichnet, dass** im Bereich der Anschlussfahnen (10) entlang des Stegs (16) durch diese Aufsteckbereiche (17) definiert sind, auf die die Auswerteeinheiten (18), die Leiterbahnen (4, 5, 6) des jeweiligen Anschlussbereichs (9) kontaktierend, aufgesteckt sind.

10. Verfahren zur Herstellung eines Profilteils (14) mit Berührungssensoren, wobei in einem ersten Schritt eine Funktionsfolie (1) nach einem der Ansprüche 1 bis 5 auf den Profilkörper (15) eines Endlosprofils aufgebracht wird, insbesondere durch Kaschieren, in einem zweiten Schritt das Profilteil (14) einer gewünschten Länge von dem Endlosprofil abgelängt wird und in einem dritten Schritt wenigstens eine Auswerteeinheit (18) an den wenigstens einen Anschlussbereich (9) auf dem Profilteil (14) angeschlossen wird.

## Claims

1. Functional film (1) for application to a profiled part (14) which can be cut to any desired length, in particular to a continuous profile, comprising at least one circuit-carrier layer (3) with periodically repeating touch-sensor conductor areas (7) and operating conducting tracks (6) for conveying signals to and from the touch sensors formed by the touch-sensor conductor areas (7), wherein the functional film (1) comprises periodically repeating connection regions (9) for connecting an evaluation unit (18), in particular a microcontroller (19), for at least one touch sensor in each case,
**characterised in that** the circuit-carrier layer (3) further comprises at least one power-supply conducting track (4) and/or at least one communication conducting track (5) for the evaluation units (18), wherein the power-supply conducting track (4) and/or the communication conducting track (5) in each case is guided from one connection region (9) to the next connection region (9).

2. Functional film according to Claim 1, **characterised in that** one connection region (9) is provided in each case for at least ten touch sensors.

3. Functional film according to one of the preceding claims, **characterised in that** the touch sensors succeed one another in the longitudinal direction of the functional film (1), wherein the connection regions (9) which likewise succeed one another in the longitudinal direction are provided on terminal lugs (10) formed laterally out of the functional film (1).

4. Functional film according to Claim 3, **characterised in that** the terminal lugs (10) are formed to be applied bent on an edge and/or to be introduced into a groove of the profile body (15) of the profiled part (14) which is adapted to the functional film (1).

5. Functional film according to one of the preceding claims, **characterised in that** in addition to the circuit-carrier layer (3) at least one additional layer (8) which is decorative and/or mechanically stabilising and/or acts as a shield layer (11) and/or comprises a shield layer (11) is provided and/or the functional film (1) is wound on a carrier roll.

6. Profiled part (14), having a profile body (15), a functional film (1) according to one of the preceding claims continuously applied, in particular laminated on, to at least one side of the profile body (15), and evaluation units (18), in particular microprocessors (19), connected to the connection regions (9).

7. Profiled part according to Claim 6, **characterised in that** the profile body (15) comprises a crosspiece (16), on the one side of which the terminal lugs (10) formed laterally out of the functional film (1) with the connection regions (9) lie bent away from the rest of the functional film (1).

8. Profiled part according to Claim 7, **characterised in that** the length of the terminal lugs (10) corresponds to the height of the crosspiece (16).

9. Profiled part according to Claim 7 or 8, **characterised in that** in the region of the terminal lugs (10) along the crosspiece (16) plugging-on regions (17) are defined by said lugs, onto which regions the evaluation units (18) are plugged, contacting the conducting tracks (4, 5, 6) of the respective connection region (9).

10. Method for producing a profiled part (14) with touch sensors, wherein in a first step a functional film (1) according to one of Claims 1 to 5 is applied to the profile body (15) of a continuous profile, in particular by lamination, in a second step the profiled part (14) is cut to a desired length from the continuous profile, and in a third step at least one evaluation unit (18) is connected to the at least one connection region (9) on the profiled part (14).

## Revendications

1. Film fonctionnel (1) à appliquer sur une pièce profilée (14) sectionnable à volonté, en particulier sur un profilé continu, comportant au moins une couche formant support de circuit (3) dotée de surfaces conductrices de capteur de contact (7) et de pistes conductrices de fonctionnement (6) se répétant régulièrement, destinées au transport de signaux en direction des capteurs de contact formés par les surfaces conductrices de capteur de contact (7) et en provenance de ceux-ci, le film fonctionnel (1) comportant des zones de raccordement (9) se répétant régulièrement, destinées au raccordement d'une unité d'évaluation (18), en particulier d'un microcontrôleur (19), pour respectivement au moins un capteur de contact,
**caractérisé en ce que** la couche formant support de circuit (3) comporte en outre au moins une piste conductrice d'alimentation en énergie (4) et/ou au moins une piste conductrice de communication (5) pour les unités d'évaluation (18), la piste conductrice d'alimentation en énergie (4) et/ou la piste conductrice de communication (5) allant respectivement d'une zone de raccordement (9) à la zone de raccordement (9) suivante.

2. Film fonctionnel selon la revendication 1, **caractérisé en ce qu'**une zone de raccordement (9) est prévue respectivement pour au moins dix capteurs de contact.

3. Film fonctionnel selon l'une des revendications précédentes, **caractérisé en ce que** les capteurs de contact se suivent les uns les autres dans le sens longitudinal du film fonctionnel (1), les zones de raccordement (9) également successives dans le sens longitudinal étant prévues sur des languettes de raccordement (10) réalisées dépassant latéralement du film fonctionnel (1).

4. Film fonctionnel selon la revendication 3, **caractérisé en ce que** les languettes de raccordement (10) sont conçues pour être appliquées de manière pliée sur un bord et/ou pour être insérées dans une rainure du corps de profilé (15) de la pièce profilée (14) adapté au film fonctionnel (1).

5. Film fonctionnel selon l'une des revendications précédentes, **caractérisé en ce que**, en plus de la couche formant support de circuit (3), au moins une couche supplémentaire (8) décorative et/ou mécaniquement stabilisatrice et/ou agissant comme couche de blindage (11) et/ou comprenant une couche de blindage (11) est prévue et/ou le film fonctionnel (1) est enroulé sur un rouleau de support.

6. Pièce profilée (14), comportant un corps de profilé (15), un film fonctionnel (1) selon l'une des revendications précédentes appliqué en continu, en particulier contrecollé, sur au moins un côté du corps de profilé (15), et des unités d'évaluation (18), en particulier des microprocesseurs (19), raccordées aux zones de raccordement (9).

7. Pièce profilée selon la revendication 6, **caractérisée en ce que** le corps de profilé (15) comporte une âme (16), sur un côté de laquelle les languettes de raccordement (10) réalisées dépassant latéralement du film fonctionnel (1), avec les zones de raccordement (9), s'appliquent pliées par rapport au reste du film fonctionnel (1).

8. Pièce profilée selon la revendication 7, **caractérisée en ce que** la longueur des languettes de raccordement (10) correspond à la hauteur de l'âme (16).

9. Pièce profilée selon la revendication 7 ou 8, **caractérisée en ce que** des zones d'enfichage (17) sont définies dans la zone des languettes de raccordement (10) le long de l'âme (16) et par celles-ci, sur lesquelles les unités d'évaluation (18) sont enfichées, en contact avec les pistes conductrices (4, 5, 6) de la zone de raccordement (9) respective.

10. Procédé de fabrication d'une pièce profilée (14) dotée de capteurs de contact, dans lequel, dans une première étape, un film fonctionnel (1) selon l'une des revendications 1 à 5 est appliqué, en particulier par contrecollage, sur le corps de profilé (15) d'un profilé continu, dans une deuxième étape, la pièce profilée (14) est sectionnée du profilé continu à une longueur souhaitée et dans une troisième étape, au moins une unité d'évaluation (18) est raccordée à l'au moins une zone de raccordement (9) sur la pièce profilée (14).
